# EUROPEAN PATENT APPLICATION

(11) **EP 4 549 445 A1**
(43) Date of publication of application: **07.05.2025**
(21) Application number: 23831858.8
(22) Date of filing: 27.06.2023
(51) Int. Cl.: C07F 7/24, H10K 30/10, H10K 39/32

(54) **PEROVSKITE HALIDE THIN FILM FOR ABSORBING BLUE LIGHT AND ELECTRONIC DEVICE COMPRISING SAME**

(30) Priority: 30.06.2022 KR 20220080299
(71) Applicant: Kyungpook National University Industry-Academic Cooperation Foundation, Daegu 41566 (KR); Research & Business Foundation Sungkyunkwan University, Suwon-si, Gyeonggi-do 16419 (KR)
(72) Inventor: LEE, Sangwook, Daegu 41528 (KR); YUN, Yeonghun, Daegu 41569 (KR); JUNG, Hyun Suk, Seoul 05502 (KR); HAN, Gill Sang, Suwon-si Gyeonggi-do 16353 (KR); PARK, Gyuna, Suwon-si Gyeonggi-do 16357 (KR); SOHN, Changhwun, Busan 48516 (KR)
(74) Representative: Schiweck Weinzierl Koch Patentanwälte Partnerschaft mbB
(86) International application number: PCT/KR2023/008913
(87) International publication number: WO 2024/005498

(57) **Abstract**

The present invention provides a thin film comprising a perovskite halide represented by chemical formula 1.

[Chemical formula 1] AB(BrₓCl_{y})₃

wherein, A is a monovalent cation consisting of a combination of NH₂CHNH₂⁺ (formamidinium, FA), CH₃NH₃⁺ (methyl ammonium, MA) and Cs⁺, wherein FA is included in an amount of 0.2 - 0.8 moles with respect to 1 mole of the monovalent cation, B is at least one divalent cation selected from Pb²⁺, Sn²⁺, Ge²⁺, Ti²⁺, Zr²⁺, Mn²⁺, Ni²⁺, Fe²⁺, Zn²⁺ and Cu²⁺, and x and y satisfy 0.5≤x≤0.8, 0.2≤y≤0.5, and x+y=1.

## Description

### Technical Field

The present invention relates to a perovskite halide thin film effective in absorbing blue light and an electronic device including same.

### Background Art

Perovskite (PVSK) halides have excellent light absorption and charge transport capabilities, and are actively being studied for application as electronic materials for image sensors, optical sensors, solar cells, light-emitting diodes, etc.

Specifically, the organic/inorganic perovskite halides are represented by ABX₃ (where A is a cation composed of an organic substance, a metal component, or a combination thereof, B is a central metal, and X is an anion of a halogen element) and have a three-dimensionally connected octahedral structure with six halogen elements (X) positioned around a central metal (B) and cations (A) positioned at eight corners, resulting in excellent absorption and photoelectric properties, easy control of the energy band gap, and maximization of photodetection characteristics within the visible light range without a color filter.

To date, the optoelectronic properties and environmental stability of perovskite-based electronic devices have been improved by strategies of changing the cation composition of A, the anion composition of B, or the halogen anion composition of X in the structure of ABX₃.

The architecture of the next-generation image sensor with a novel design of vertically stacked photodetectors (PDs) consists of three different perovskite photodetectors (PPDs) that selectively absorb blue, green, and red light. Research is being conducted on the basis that pixels can be integrated and quantum efficiency can be maximized by stacking each layer without a color filter.

However, most of the existing perovskite halide thin films are related to electronic devices corresponding to red and green in the visible spectrum, and research on the composition corresponding to the blue region (380 to 500 nm) is insufficient.

Accordingly, perovskite halide thin films that can effectively achieve stable and sufficient light absorption in the blue region of the visible spectrum are required.

### Detailed Description of the Invention

### Technical Problem

The present invention is intended to solve the problems of the prior art as described above, and provides a thin film that can selectively absorb only blue light (380 to 500 nm) by applying a combination of certain compositions to the cation at the A site and the halogen anion at the X site in a perovskite halide of ABX₃.

In addition, the present invention provides an electronic device comprising the perovskite halide thin film for absorbing blue light.

### Solution to Problem

According to one aspect of the present invention, a thin film comprising a perovskite halide represented by the following chemical formula 1 is provided:

[Chemical Formula 1] AB(BrₓCl_{y})₃

wherein,
A is a monovalent cation consisting of a combination of NH₂CHNH₂⁺ (formamidinium, FA), CH₃NH₃⁺ (methyl ammonium, MA) and Cs⁺, wherein FA is included in an amount of 0.2 - 0.8 moles with respect to 1 mole of the monovalent cation,
B is at least one divalent cation selected from Pb²⁺, Sn²⁺, Ge²⁺, Ti²⁺, Zr²⁺, Mn²⁺, Ni²⁺, Fe²⁺, Zn²⁺ and Cu²⁺, and
x and y satisfy 0.5≤x≤0.8, 0.2≤y≤0.5, and x+y=1.

The above perovskite halide may have a content of MA among monovalent cations of 0.2 to 0.6 moles with respect to 1 mole of monovalent cation.

The above perovskite halide may have a content of Cs⁺ among monovalent cations of 0.01 to 0.2 moles with respect to 1 mole of monovalent cation.

The above perovskite halide may include a composition of (FA_{0.6}MA_{0.35}Cs_{0.05})Pb(Br_{0.65}Cl_{0.35})₃.

According to another aspect of the present invention, an electronic device manufactured using the perovskite halide thin film is provided.

### Effect of the Invention

According to the present invention, by mixing the Cs ion with an organic combination of FA (formamidinium) and MA (methyl ammonium) at the monovalent cation site of A in the perovskite halide of ABX₃, while controlling the ratio of FA to be in the range of 0.2 to 0.8 mole with respect to 1 mole of the monovalent cation and further controlling the ratio to a predetermined range through composing the halogen ion at the X site of a combination of Br and Cl, a band gap that can absorb only blue light without absorbing green/red light due to fast response to blue light (380 to 500 nm) can be achieved, excellent photoconversion characteristics can be realized due to formation of a dense thin film composed of uniform particles with few defects, and excellent stability against moisture and air can be exhibited based on a thermodynamically stabilized crystal structure.

Therefore, the perovskite halide thin film of the present invention implements the effect of stably absorbing blue light of the visible spectrum by itself, and thus it is also advantageous from an economic perspective because it does not require additional components such as color filters for application to electronic devices.

### Brief description of the drawing

Fig. 1 is a schematic diagram illustrating the crystal structure of a perovskite halide according to one embodiment of the present invention and the absorption of blue light to induce electron generation.
Fig. 2 is a schematic diagram of a photodetector to which a perovskite halide thin film according to one embodiment of the present invention is applied.
Figs. 3a to 3f show comparisons of the characteristics of perovskite halide thin films based on FAMACs according to Experimental Example 1 as a function of the FA ratio.
Figs. 4a to 4c, 5a to 5f, and 6a to 6g show comparisons of the characteristics of perovskite halide thin films according to Experimental Example 2 as a function of the incorporation of Cs into the cation site.

### Best Mode for Carrying out the Invention

Hereinafter, the present invention will be described in detail with reference to the drawings. The terms or words used in this specification and claims should not be interpreted as limited to their usual or dictionary meanings, but should be interpreted as having meanings and concepts that conform to the technical idea of the present invention, based on the principle that the inventor can appropriately define the concept of the term in order to explain his or her own invention in the best manner.

In addition, it should be understood that the embodiments described in this specification and the configurations illustrated in the drawings are only the most preferred embodiments of the present invention and do not represent all of the technical ideas of the present invention, and therefore various equivalents and modifications may be available as of the time of filing this application.

The present invention is based on organic-inorganic halide perovskites (PVSK), particularly perovskites of ABX₃, where A is NH₂CHNH₂⁺ (formamidinium, FA) and CH₃NH₃⁺ (methyl ammonium, MA), and X⁻ site ions are composed of Br and Cl. In the case of perovskite compositions for blue light-receiving devices in which X⁻ site ions are composed of Br and Cl, as the formation enthalpy is low, nucleation occurs at room temperature during the thin film formation process, which can form a thin film with non-uniform and non-dense morphology through non-uniform nucleation and particle growth. Accordingly, the inventors of the present invention studied a method of controlling nucleation, and as a result, they discovered that by controlling the composition ratio of FA and MA and also adding Cs, the blue light receiving characteristics are significantly improved, thereby completing the present invention.

That is, the research results of the present inventors shows that when the molar ratio of FA and MA satisfies a certain range, a dense perovskite thin film composed of uniform particles with few defects can be formed, which can overcome the limitation of inducing a thin film with an unclear and rough surface due to low formation energy in the Br/Cl combination at the X⁻ site. When applied to electronic devices, thin films with such a dense structure can implement excellent photoconversion characteristics by increasing the photocurrent density while lowering the dark current density by reducing the leakage current due to charge injection from adjacent layers.

In addition, according to the research of the present inventors, the Cs⁺ ion positioned at the site of the monovalent cation (A) is smaller than the two types of FA⁺ and MA⁺, which controls the stress within the crystal lattice to suppress the formation of defects, thereby suppressing charge recombination. In addition, the separation of the A-site component and the X-site component can be suppressed, thereby promoting the uniform distribution of the perovskite halide during thin film formation. Additionally, the incorporation of Cs⁺ ions had little effect on the bandgap energy. Therefore, the cationic combination of FA/MA/Cs could induce a thermodynamically stabilized crystal structure compared to the combination of FA/MA, thereby reducing the density of charge trapping defects and improving the lifetime and mobility of charge carriers during the formation of perovskite thin films. As a result, charge transport and responsivity to blue light (380 to 500 nm) could be improved.

One embodiment of the present invention according to the research results relates to a thin film including a perovskite halide represented by the following chemical formula 1.

[Chemical Formula 1] AB(BrₓCl_{y})₃

wherein,
A is a monovalent cation consisting of a combination of NH₂CHNH₂⁺ (formamidinium, FA), CH₃NH₃⁺ (methyl ammonium, MA) and Cs⁺, wherein FA is included in an amount of 0.2 - 0.8 moles with respect to 1 mole of the monovalent cation,
B is at least one divalent cation selected from Pb²⁺, Sn²⁺, Ge²⁺, Ti²⁺, Zr²⁺, Mn²⁺, Ni²⁺, Fe²⁺, Zn²⁺ and Cu²⁺, and
x and y satisfy 0.5≤x≤0.8, 0.2≤y≤0.5, and x+y=1.

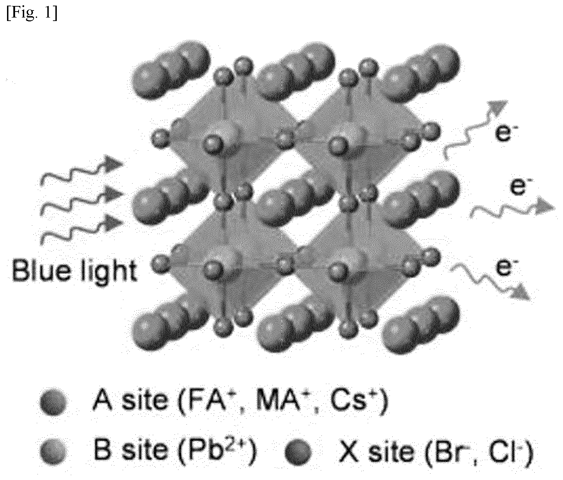

Fig. 1 is a schematic diagram illustrating the crystal structure of a perovskite halide according to one embodiment of the present invention and the absorption of blue light to induce electron generation.

Referring to Fig. 1, the perovskite halide of formula 1 according to the present invention has a three-dimensionally connected octahedral crystal structure in which a combination of Br⁻ and Cl⁻ is positioned as six halogen elements (X) around a central metal (B), for example, Pb²⁺, and a combination of FA⁺, MA⁺, and Cs⁺ is positioned as monovalent cations (A) at eight corners.

In this crystal structure, the Cs⁺ ion positioned at the site of the monovalent cation (A) is smaller than the two types of FA⁺ and MA⁺, which controls the stress within the crystal lattice to suppress the formation of defects, thereby suppressing charge recombination. In addition, the separation of the A-site component and the X-site component can be suppressed, thereby promoting the uniform distribution of the perovskite halide during the formation of the thin film. Meanwhile, the incorporation of Cs⁺ ions has little effect on the bandgap energy. Therefore, the cationic combination of FA/MA/Cs can induce a thermodynamically stabilized crystal structure compared to the combination of FA/MA, thereby reducing the density of charge trapping defects and improving the lifetime and mobility of charge carriers during the formation of perovskite thin films. As a result, charge transport and responsivity to blue light (380 to 500 nm) could be improved when applied to electronic devices.

In the perovskite halide according to one embodiment of the present invention, FA included in the monovalent cation (A) combination may be in the range of 0.2 to 0.8 moles, preferably 0.4 to 0.7 moles, and more preferably 0.5 to 0.65 moles, with respect to 1 mole of the monovalent cation.

When the mole number of the above FA satisfies the above range, a dense perovskite thin film composed of uniform particles with few defects can be formed, which can overcome the limitation of inducing a thin film with an unclear and rough surface due to low formation energy in the Br/Cl combination at the X⁻ site. When applied to electronic devices, thin films with such a dense structure can implement excellent photoconversion characteristics by increasing the photocurrent density while lowering the dark current density by reducing the leakage current due to charge injection from adjacent layers.

The above perovskite halide may have a content of MA among monovalent cations of 0.2 mole or more, 0.25 mole or more, or 0.3 mole or more, and 0.6 mole or less, 0.4 mole or less, or 0.35 mole or less, with respect to 1 mole of monovalent cation, and preferably 0.3 mole to 0.45 mole. In addition, the content of Cs⁺ among monovalent cations may be 0.01 mole or more, 0.02 mole or more, 0.03 mole or more, 0.04 mole or more, or 0.05 mole or more, and 0.2 mole or less, 0.15 mole or less, 0.1 mole or less, 0.09 mole or less, 0.08 mole or less, 0.07 mole or less, or 0.06 mole or less, with respect to 1 mole of monovalent cation, and preferably 0.03 mole or more and 0.06 mole or less. Additionally, according to a preferred embodiment, the content of MA may be 0.5 to 0.7 moles and the content of Cs⁺ may be 0.08 to 0.09 moles with respect to 1 mole of FA. When the molar content and molar ratio of the above MA and Cs⁺ satisfy the above ranges, it is advantageous in that it can form a dense and uniform thin film (in terms of the FA: MA ratio) by controlling nucleation and crystallization of the perovskite phase, and it can suppress recombination of photogenerated charges by reducing stress within the lattice and facilitate charge transfer (in terms of Cs).

In addition, the perovskite halide according to one embodiment of the present invention has a band gap (about 2.5 eV) capable of absorbing blue light (380 to 500 nm) through the Br/Cl combination located at the halogen element (X) site.

In one embodiment of the present invention, Br at the X- site may be included in an amount of 0.5 mole or more, or 0.6 mole or more, and 0.8 mole or less, or 0.7 mole or less, or 0.65 mole or less, with respect to 1 mole of the halogen element combination, and preferably 0.6 mole to 0.7 mole. And Cl may be included in an amount of 0.2 mole or more, 0.3 mole or more, or 0.35 mole or more, and 0.5 mole or less, or 0.4 mole or less, and preferably 0.3 mole to 0.4 mole. Additionally, according to a preferred embodiment, the molar ratio of Br and Cl, x/y can be from 1.6 to 2, or from 1.7 to 1.9 or less.

When the content and molar ratio of Br and Cl satisfy the above range, it is advantageous in that blue light (380 nm to 500 nm) can be sufficiently absorbed.

For example, the perovskite halide thin film of the present invention may include a composition of (FA_{0.6}MA_{0.35}Cs_{0.05})Pb(Br_{0.65}Cl_{0.35})₃, and (FA_{0.6}MA_{0.35}Cs_{0.05})Pb(Br_{0.65}Cl_{0.35})₃ can realize particularly excellent photoconversion characteristics.

Meanwhile, the perovskite halide thin film of the present invention can be manufactured by a process including a step (S1) of dissolving precursors such as formamidinium bromide (FABr), formamidinium chloride (FACl), methyl ammonium bromide (MABr), methyl ammonium chloride (MACl), CsBr, and a powder of a central metal halide (e.g., PbBr₂, PbCl₂) in a polar solvent and spin-coating the obtained solution on a substrate; a step (S2) of additionally spraying a nonpolar solvent as an anti-solvent to promote crystallization of the thin film during the spin-coating process; and a step (S3) of heat-treating the resultant coating layer.

In the above step (S1), the content ratio between each precursor used can be appropriately selected according to the composition of chemical formula 1 in the present invention.

In the present invention, the step (S1) of spin coating, the step (S2) of crystallization using an anti-solvent, and the step (S3) of heat treatment may each be performed in a manner conventional in the art, and there is no particular limitation.

In addition, the thickness of the perovskite halide thin film manufactured by the above process can be adjusted to an appropriate range to improve the characteristics of electronic devices by controlling the molar concentration of the solution.

In one embodiment of the present invention, at least one selected from dimethyl sulfoxide (DMSO), dimethylformamide (DMF), ethanol, isopropanol, butanol, methanol, benzyl alcohol ethyl acetate, tetrahydrofuran, dichloromethane, acetonitrile, trimethylphosphate, hexamethylphosphoramide, and water may be used as the polar solvent.

As the above nonpolar solvent, at least one selected from diethyl ether (DEE), dipropyl ether (DPE), cyclohexane, chlorobenzene, toluene, xylene, and chloroform can be used.

The perovskite halide thin film of the present invention manufactured as described above may exhibit a band gap energy (approximately 2.5 eV) that can absorb only blue light without absorbing green/red light due to its fast response to blue light (380 to 500 nm) and have excellent photoconversion characteristics due to formation of a dense thin film composed of uniform particles with few defects.

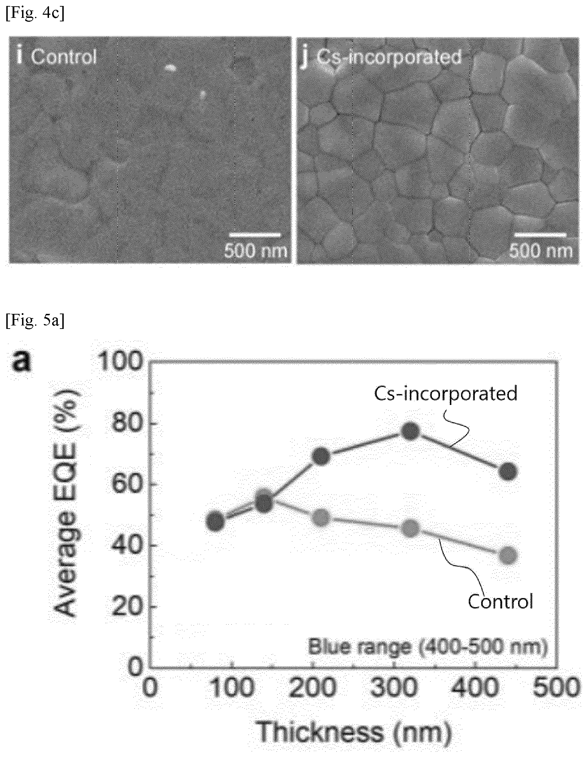

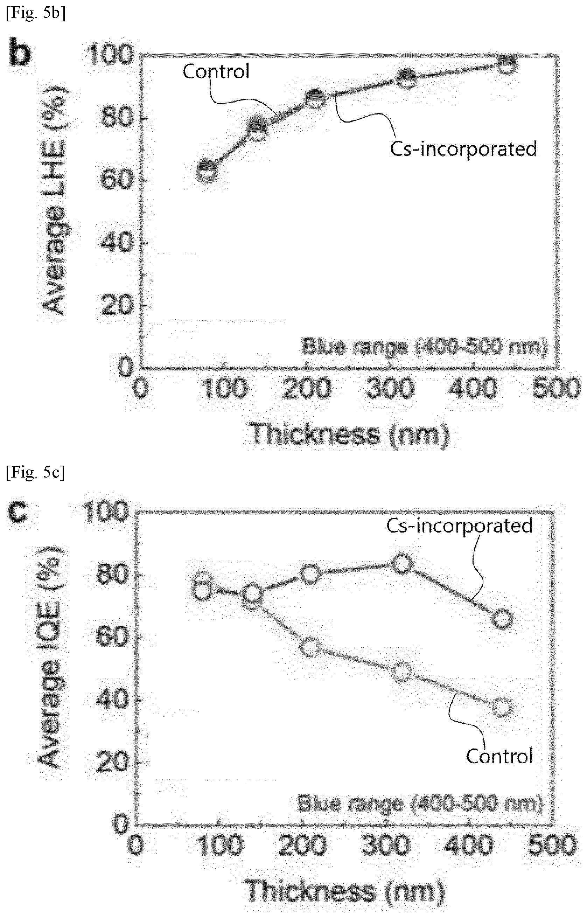

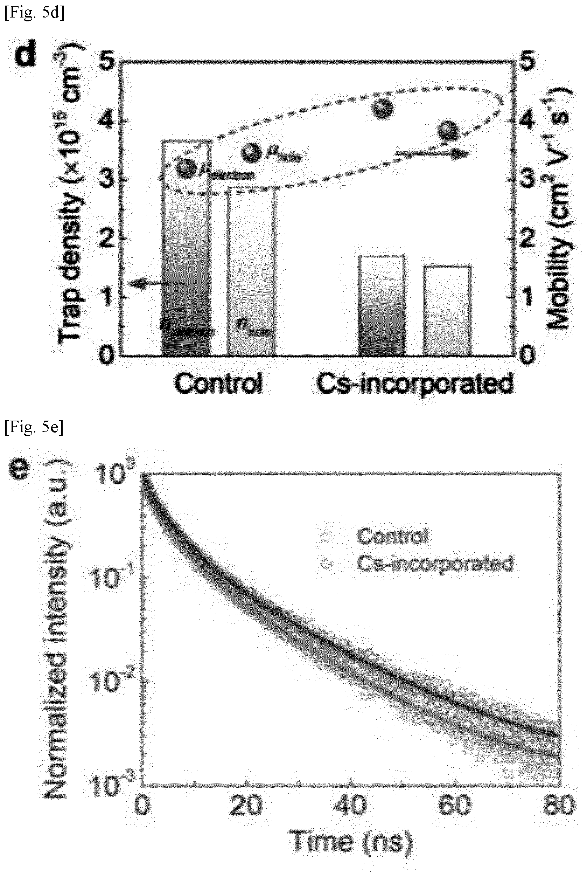

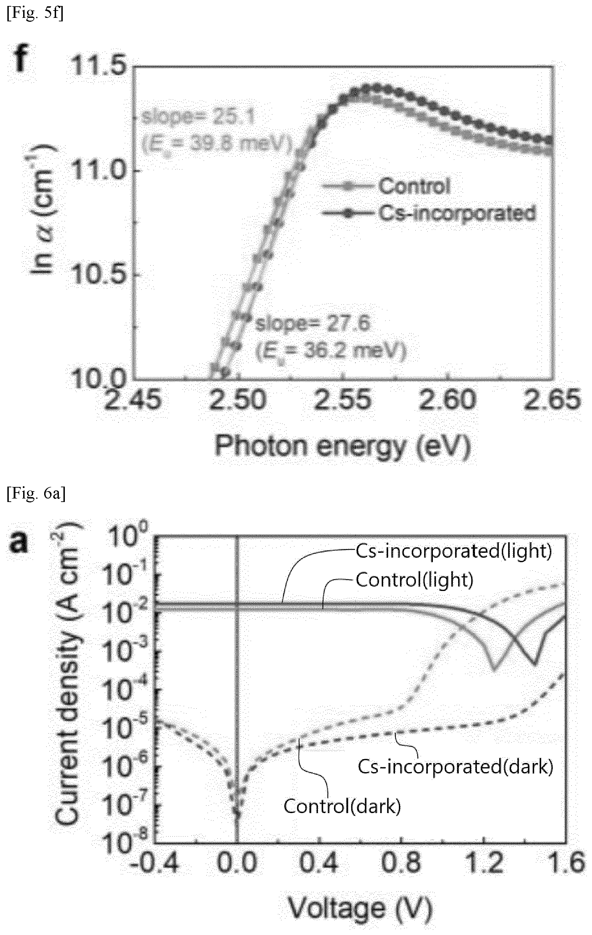

Specifically, the perovskite halide thin film of the present invention may have a thickness range of 70 to 500 nm, and may exhibit an average external quantum efficiency (EQE) of 40 to 80% in a blue light range of 380 to 500 nm, a responsivity of 0.24 to 0.32 AW⁻¹ in a blue light range of 380 to 500 nm, and a detectivity of 3×10¹² to 6×10¹² Jones in a blue light range of 380 to 500 nm (see Fig. 5).

In this way, the perovskite halide thin film of the present invention achieves the effect of stably and sufficiently absorbing blue light of the visible spectrum by itself, and thus it is also advantageous from an economic perspective because it does not require additional components such as color filters for application to electronic devices.

Accordingly, the present invention provides an electronic device including a photodetector device, an image sensor device, etc. manufactured using the perovskite halide thin film.

Meanwhile, it is expected that the perovskite halide thin film of the present invention can also be applied to light-emitting diode (LED) devices, solar cells, or photoelectric conversion devices.

### Embodiments for carrying out the invention

Hereinafter, in order to help understand the present invention, examples will be given in detail. However, the embodiments according to the present invention may be modified in various different forms, and the scope of the present invention should not be construed as being limited to the following embodiments. Embodiments of the present invention are provided to more fully describe the present invention to those of ordinary skill in the art.

### Example 1: Fabrication of FAMACs-based perovskite halide thin films

First, raw material powders of FABr (formamidinium bromide), FACl (formamidinium chloride), MABr (methyl ammonium bromide), MACl (methyl ammonium chloride), CsBr, PbBr₂, and PbCl₂ were prepared as precursors, respectively.

A 1.0 M solution of (FA_{0.6}MA_{0.35}Cs_{0.05})Pb(Br_{0.65}Cl_{0.35})₃ was obtained by dissolving FACl (0.6 mmol), MABr (0.35 mmol), CsBr (0.05 mmol), PbBr₂ (0.775 mmol), and PbCl₂ (0.225 mmol) in a mixed solvent of 0.5 ml of dimethylformamide (DMF) and 0.5 ml of dimethyl sulfoxide (DMSO).

The perovskite halide thin film was prepared by dropping the obtained solution onto the substrate that had been UV-ozone treated for 20 minutes and then spin-coating at 4000 rpm for 30 seconds.

For a thin film with uniform morphology, 0.5 mL of diethyl ether (DEE) was sprayed 3 seconds before the end of spin coating. After the spin coating, the residual solvents were removed by heat treatment at 65°C and 100°C for 1 minute and 10 minutes, respectively, to produce a perovskite halide thin film.

### Comparative Example 1: Fabrication of FAMA-based perovskite halide thin films

A thin film having a mixed composition of FA and MA (FAₓMA₁₋ₓ(Br_{0.65}Cl_{0.35})₃) (wherein x is 0 to 1) was obtained by dissolving each of the above perovskite halide powder in a mixed solvent of dimethylformamide and dimethyl sulfoxide at a concentration of 1.0 M, corresponding to the formulas of FAPb(Br_{0.65}Cl_{0.35})₃ and MAPb(Br_{0.65}Cl_{0.35})₃, and then mixing the FAPb(Br_{0.65}Cl_{0.35})₃ and MAPb(Br_{0.65}Cl_{0.35})₃ solutions in an appropriate ratio.

The formation of thin film was performed by the same process as in Example 1, and thin films were manufactured using perovskite halides of (FA_{0.6}MA_{0.4})Pb(Br_{0.65}Cl_{0.35})₃, (FA_{0.8}MA_{0.2})Pb(Br_{0.65}Cl_{0.35})₃, (FA_{0.6}MA_{0.4})Pb(Br_{0.65}Cl_{0.35})₃, (FA_{0.4}MA_{0.6})Pb(Br_{0.65}Cl_{0.35})₃, (FA_{0.2}MA_{0.8})Pb(Br_{0.65}Cl_{0.35})₃.

### Experimental Example 1: Performance evaluation of perovskite halide thin film according to FA ratio

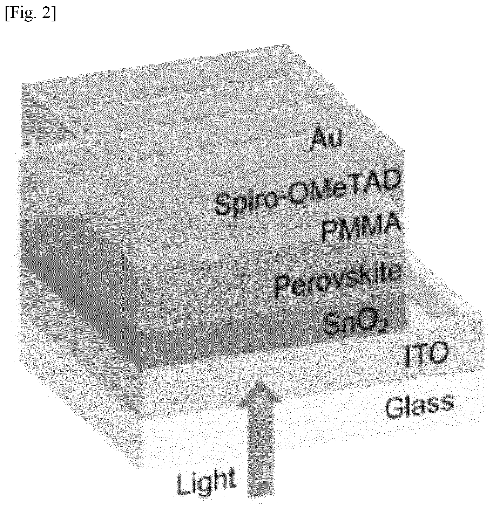

In order to find the optimal FA/MA ratio for absorption and emission of blue light in (FA/MA/Cs)Pb(Br/Cl)₃-based perovskite halide thin films, the thin films were manufactured by varying the ratio of FA to the monovalent cation site during the synthesis of perovskite halide thin films and then applied to a photodetector device having a configuration as shown in Fig. 2.

The photodetector of Fig. 2 is composed of a stack of ITO (tin doped indium oxide)/SnO₂/PVSK/PMMA/Spiro-OMeTAD/Au on a glass substrate, wherein the perovskite (PVSK) thin film, which is a light-absorbing layer, was adjusted to a range of 140 to 170 nm regardless of the composition (FA ratio), and a blue wavelength of 450 nm laser was used as a light source at an intensity of 63.0 mW/cm².

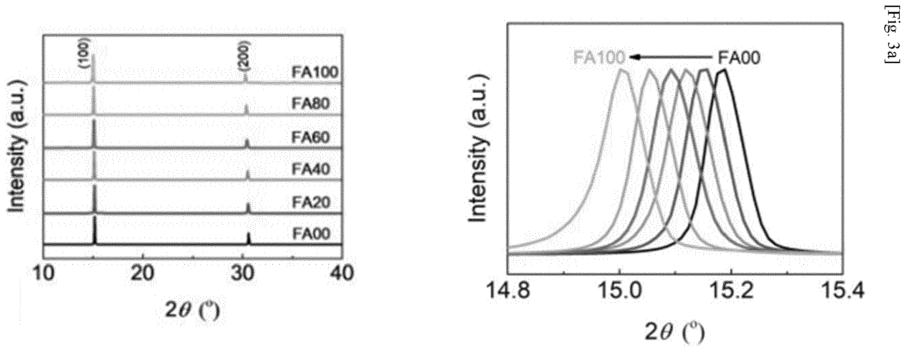

Figs. 3a to 3f show comparisons of the characteristics of perovskite halide thin films as a function of the FA ratio.

Specifically, Fig. 3a shows the results of the XRD (X-ray diffraction) analysis of each thin film. In the graph on the left, two high peaks appeared at approximately 15 degrees and 30 degrees belonging to the (100) and (200) planes regardless of the ratio of FA, and in the graph on the right, the main peak shifted downward as the ratio of FA increased.

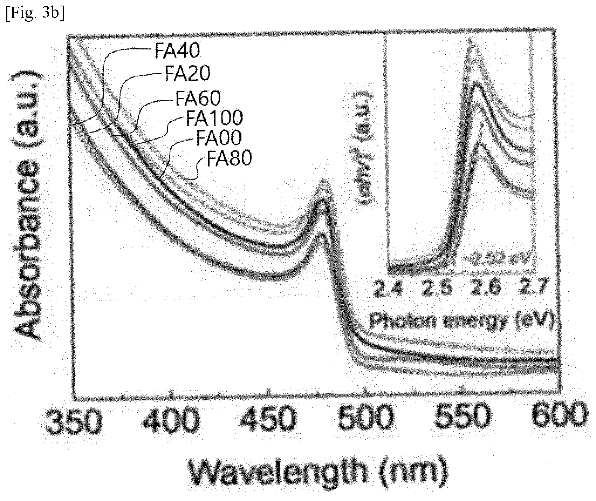

Fig. 3b shows the UV-Vis spectroscopy analysis results for each thin film, which had similar band edge at about 500 nm and optical band gap energy of about 2.5 eV. That is, even if the FA ratio changes in the perovskite halide thin films, the change in the band gap energy is almost negligible, because the conduction band minimum (CBM) and valence band minimum (VBM) of the Pb-containing perovskite thin films are mainly formed by the orbital overlap of the B and X site ions.

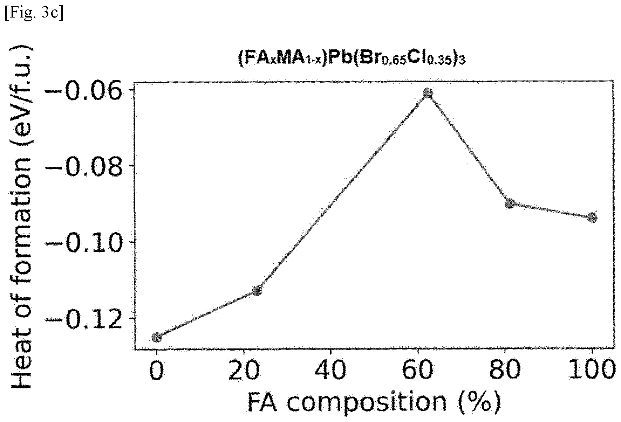

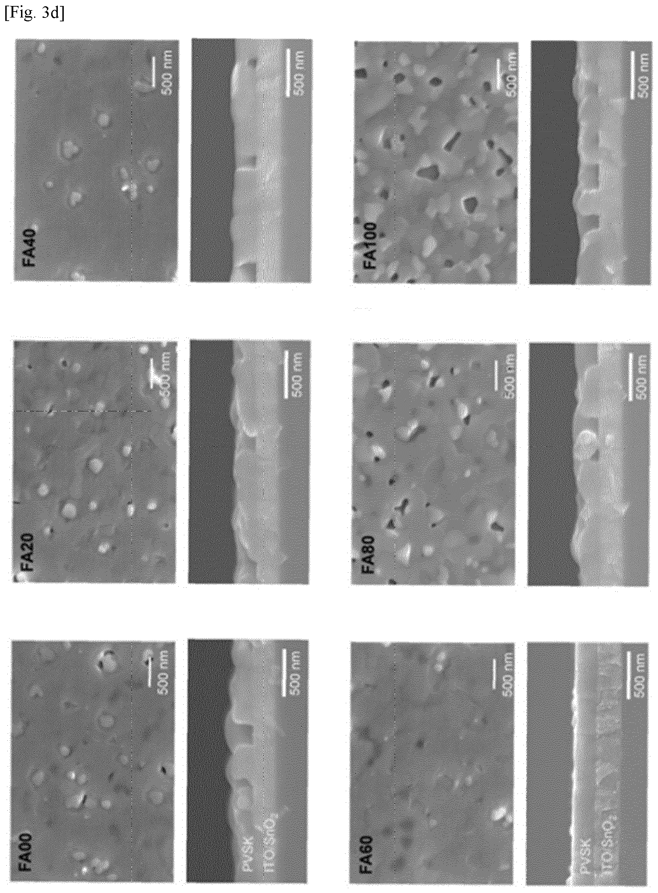

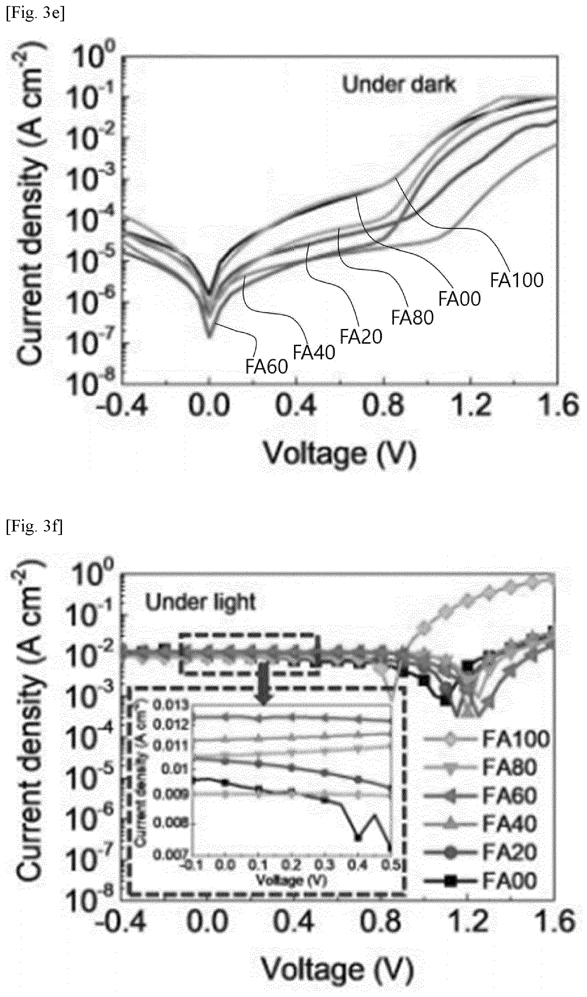

Fig. 3c shows the heat of formation as a function of the ratio of MA:FA in the composition assumed as FAₓMA₁₋ₓPbBr_{0.65}Cl_{0.35} based on the DFT simulation calculation results. The composition of x = 0 has a heat of formation energy of -0.125 eV, which can induce rapid nucleation, whereas the composition of x = 0.625 with added FA has a heat of formation of -0.061 eV, which can delay nucleation and crystallization during thin film formation. Fig. 3d shows a cross-sectional SEM image of each thin film. It can be confirmed that FA40 and FA60 have fewer pinholes on the surface, and in particular, FA60 has the most uniform and dense surface. This may be because a relatively dense and uniform thin film is formed by controlling nucleation and particle growth by applying a combination of Br/Cl as a halogen element and a combination of FA/MA/Cs as a cation with including FA at 20 to 80% of the total cation. Fig. 3e shows the dark current density (J_{d}) of each thin film. The dark current density at zero bias showed a deviation of about 10⁻⁷ to 10⁻⁶ A/cm², and in particular, the FA60 thin film had the lowest dark current density at zero bias of 1.41×10⁻⁷ A/cm². This is considered to be due to the reduced leakage current caused by charge injection from adjacent layers in the photodetector, as the FA60 thin film has a dense structure with few defects.

Fig. 3f shows the photocurrent density (Jₚₕ) of each thin film, and the FA60 thin film showed the highest photocurrent density of 1.24×10⁻² A/cm².

The above photocurrent density indicates the conversion of an optical signal into an electrical signal, and a constant and saturated level of the photocurrent density means that an extremely low or even zero voltage is sufficient to transfer photoexcited charge carriers from the perovskite thin film layer to the electron transport layer and hole transport layer, suggesting that the FA60 thin film with the highest photocurrent density has the best photoconversion characteristics.

### Experimental Example 2: Performance evaluation of perovskite halide thin films with Cs-incorporated

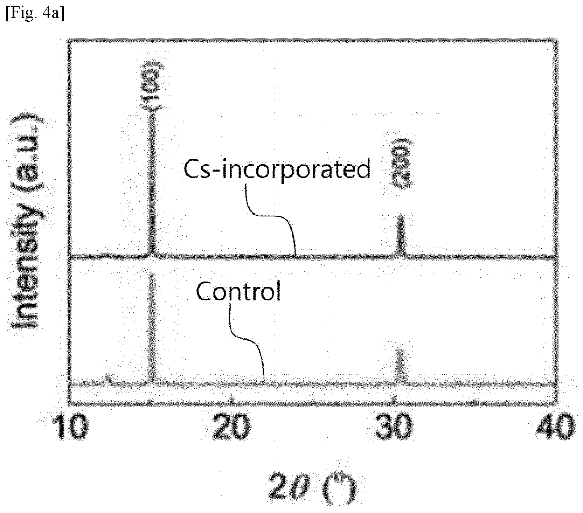

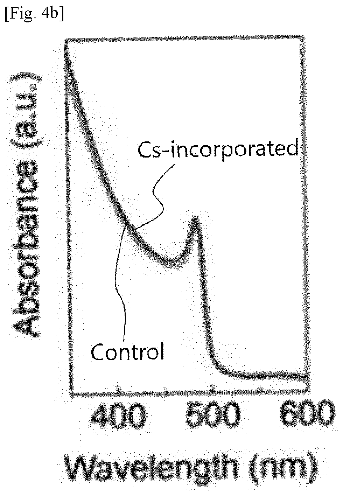

In order to compare the characteristics as a function of the incorporation of Cs into the cation site of the perovskite halide, the thin film of (FA_{0.6}MA_{0.35}Cs_{0.05})Pb(Br_{0.65}Cl_{0.35})₃ with Cs incorporated of Example 1 and the thin film of (FA_{0.6}MA_{0.4})Pb(Br_{0.65}Cl_{0.35})₃) of Comparative Example 1 as a control were applied to the photodetector device as in Experimental Example 1, respectively, with a thickness of 70 to 500 nm, and the performance evaluation was performed, and the results are shown in Figs. 4 to 6.

Fig. 4a shows the results of XRD analysis of each thin film. The thin film (Example 1) in which Cs⁺ (181 pm), which is smaller than MA⁺ (253 pm), was incorporated into the cation site showed an increase in crystallinity and a contraction of the crystal lattice, which shifted the position of the (100) peak and improved intensity.

Fig. 4b shows the absorption spectrum of each thin film as a function of the wavelength, and it can be confirmed that the band gap energy is hardly affected by the incorporation of Cs⁺.

Fig. 4c shows a cross-sectional SEM image of each thin film, and it can be confirmed that the perovskite halide particles included in the thin film with Cs⁺ incorporated (Example 1) in the right figure are uniform and clearly distinguished compared to the control (Comparative Example 1) in the left figure, which is a result of Cs⁺ being involved in the formation of crystal nuclei and promoting uniform crystallization and growth.

Figs. 5a to 5f show the results of blue light emission characteristics of each thin film.

The external quantum efficiency (EQE) of Fig. 5a, the light harvesting efficiency (LHE) of Fig. 5b, and the internal quantum efficiency (IQE) of Fig. 5c showed that the average values of the quantum efficiency calculated in the blue region in the thickness range of 70 to 500 nm for the Cs⁺-incorporated thin film (Example 1) were higher than those for the control (Comparative Example 1) (for reference, EQE = LHE x IQE).

In Fig. 5d, the trap densities obtained from the electron and hole arrays of the Cs⁺-incorporated thin film were calculated to be 1.69×10¹⁵/cm³ and 1.52×10¹⁵/cm³, respectively, which were half of the level of the control.

Fig. 5e compares the lifetime of charge carriers through the time-resolved photoluminescence (TRPL) decay profile, and it is confirmed that the carrier lifetime increases as the incorporation of Cs⁺ into the crystal lattice compensates for ionic defects and suppresses charge recombination.

Fig. 5f shows the integral value of the absorption coefficient (α) as a function of the proton energy. The Eu value of the Cs⁺-incorporated thin film (36.2 meV) was reduced compared to the Eu value of the control (39.8 meV), which means that the incorporation of Cs⁺ resulted in fewer trap states and increased carrier mobility, thereby improving the structural order of the thin film.

Figs. 6a to 6g show the results of the photoconversion characteristics of each thin film.

In the J-V curve of Fig. 6a, the Cs⁺-incorporated thin film (Example 1) has an increased photocurrent and a decreased dark current compared to the control (Comparative Example 1), so it has excellent photodetection characteristics and can be applied to photodetector by itself without a separate component such as a color filter.

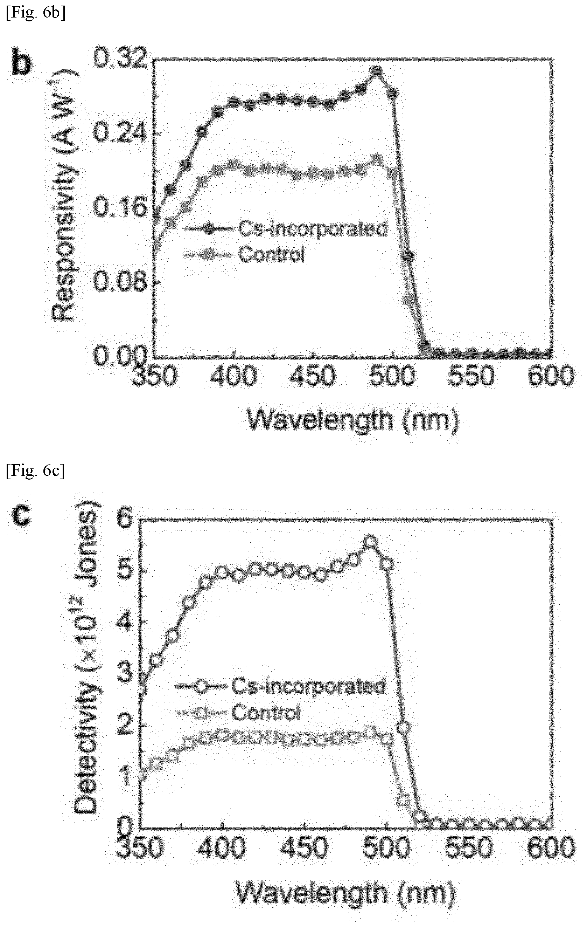

Similarly, it can be confirmed from Figs. 6b and 6c that the Cs⁺-incorporated thin film has higher maximum and average values of responsivity and detectivity than the control, which is due to the reduced dark current density and increased photocurrent density.

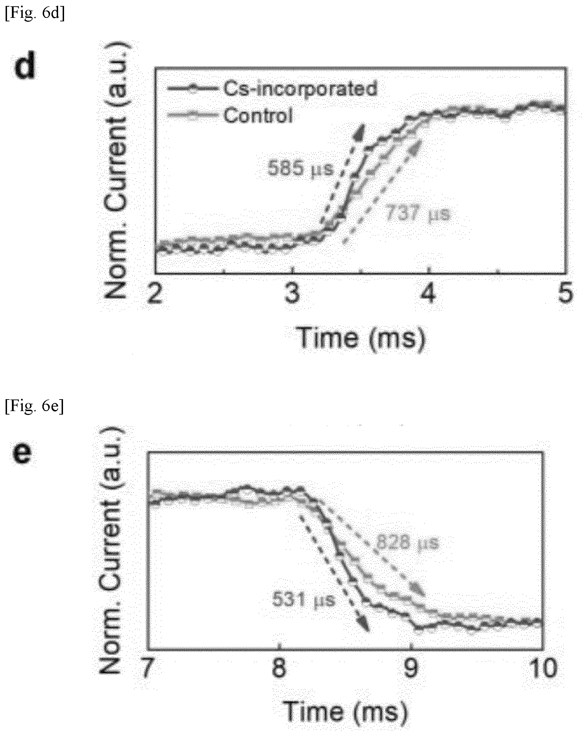

Figs. 6d and 6e show the time taken for the photocurrent to continuously rise from 10% to 90% and the time taken for it to decrease, respectively, at an optical frequency of 100 Hz at zero bias. The Cs⁺-incorporated thin film has a faster rise time and decrease time than the control, which means that the incorporation of Cs⁺ shortens the response time to blue light.

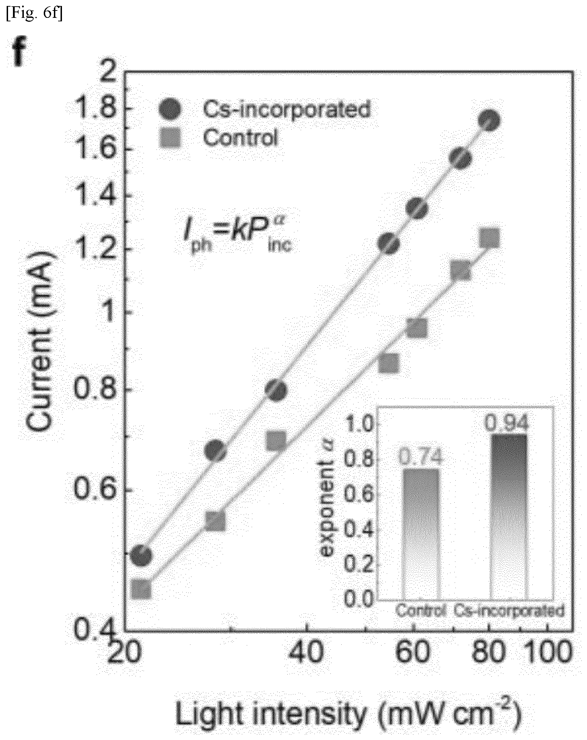

Fig. 6f shows the intensity of photocurrent as a function of the incident light intensity, and the Cs⁺-incorporated thin film shows an increased current value compared to the control.

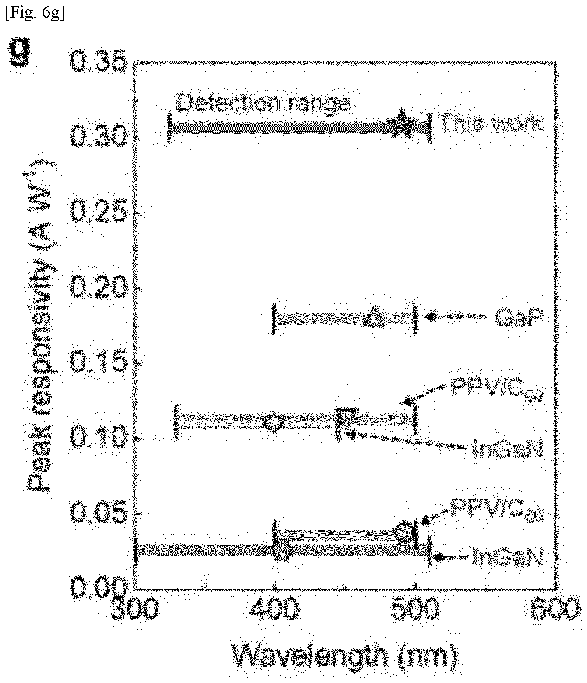

Fig. 6g shows the peak responsivity and detectivity range. The photodetector with the Cs⁺-incorporated thin film had a higher peak responsivity in the blue light wavelength range than the existing commercially available photodetectors.

As described above, according to the present invention, by mixing the Cs ion with an organic combination of FA (formamidinium) and MA (methyl ammonium) at the monovalent cation site of A in the perovskite halide of ABX₃, while controlling the ratio of FA to be in the range of 0.2 to 0.8 mole with respect to 1 mole of the monovalent cation, and further controlling the ratio to a predetermined range through composing the halogen ion at the X site of a combination of Br and Cl, a band gap that can absorb only blue light without absorbing green/red light due to fast response to blue light (380 to 500 nm) can be achieved, excellent photoconversion characteristics can be realized due to formation of a dense thin film composed of uniform particles with few defects, and excellent stability against moisture and air can be exhibited based on a thermodynamically stabilized crystal structure. Therefore, the perovskite halide thin film of the present invention implements the effect of stably absorbing blue light of the visible spectrum by itself, and thus it is also advantageous from an economic perspective because it does not require additional components such as color filters for application to electronic devices as image sensors.

## Claims

1. A thin film comprising a perovskite halide represented by chemical formula 1:
[Chemical Formula 1] AB(BrₓCl_{y})₃
wherein,
A is a monovalent cation consisting of a combination of NH₂CHNH₂⁺ (formamidinium, FA), CH₃NH₃⁺ (methyl ammonium, MA) and Cs⁺, wherein FA is included in an amount of 0.2 - 0.8 moles with respect to 1 mole of the monovalent cation,
B is at least one divalent cation selected from Pb²⁺, Sn²⁺, Ge²⁺, Ti²⁺, Zr²⁺, Mn²⁺, Ni²⁺, Fe²⁺, Zn²⁺ and Cu²⁺, and
x and y satisfy 0.5≤x≤0.8, 0.2≤y≤0.5, and x+y=1.

2. The thin film comprising a perovskite halide according to claim 1, wherein the MA is included in an amount of 0.2 to 0.6 moles with respect to 1 mole of the monovalent cation, and the Cs⁺ is included in an amount of 0.01 to 0.2 moles with respect to 1 mole of the monovalent cation.

3. The thin film comprising a perovskite halide according to claim 1, wherein the MA content is 0.5 to 0.7 moles and the Cs⁺ content is 0.08 to 0.09 moles with respect to 1 mole of FA.

4. The thin film comprising a perovskite halide according to claim 1, wherein x/y is 1.6 to 2.

5. The thin film comprising a perovskite halide according to claim 1, wherein the perovskite halide is (FA_{0.6}MA_{0.35}Cs_{0.05})Pb(Br_{0.65}Cl_{0.35})₃.

6. The thin film comprising a perovskite halide according to claim 1, wherein the thin film exhibits an average external quantum efficiency (EQE) of 40% to 80% in a thickness range of 80 to 500 nm.

7. The thin film comprising a perovskite halide according to claim 1, wherein the thin film exhibits a responsivity of 0.24 to 0.32 A/W⁻¹ in a blue light range of 380 to 500 nm.

8. The thin film comprising a perovskite halide according to claim 1, wherein the thin film exhibits a detectivity of 3×10¹² to 6×10¹² Jones in a blue light range of 380 to 500 nm.

9. An electronic device manufactured using the perovskite halide thin film according to any one of claims 1 to 8.

10. The electronic device according to claim 9, wherein the electronic device comprises a photodetector device or an image sensor device.
